# FASCICULE DE BREVET EUROPEEN

(11) **EP 0 565 414 B1**
(45) Date de publication et mention de la délivrance du brevet: **17.06.1998**
(21) Numéro de dépôt: 93400859.0
(22) Date de dépôt: 02.04.1993
(51) Int. Cl.: C30B 25/18, H01L 21/20

(54) **Procédé de réalisation de couches minces hétéroépitaxiales, et de dispositifs électroniques**
Verfahren zur Herstellung von heteroepitaxischen dünnen Schichten und elektronischen Bauelementen
Method of manufacturing heteroepitaxial thin films and electronic devices

(30) Priorité: 02.04.1992 FR 9204001
(43) Date de publication de la demande: 13.10.1993
(73) Titulaire: THOMSON-CSF, 75008 Paris (FR)
(72) Inventeur: Pribat, Didier, F-92402 Courbevoie Cedex (FR); Gerard, Bruno, F-92402 Courbevoie Cedex (FR)
(74) Mandataire: Guérin, Michel

(56) Documents cités:
- EP-A- 0 390 661
- FR-A- 2 629 637
- FR-A- 2 667 617
- JAPANESE JOURNAL OF APPLIED PHYSICS, PART2, LETTERS vol. 26, no. 10, Octobre 1987,TOKYO JP pages L1587 - L1589 A. SEKI ET AL
- APPLIED PHYSICS LETTERS. vol. 57, no. 12, 17 Septembre 1990, NEW YORK US pages 1209 - 1211 T. FUKUI ET AL

## Description

L'invention concerne un procédé de réalisation de couches minces hétéroépitaxiales et plus précisément la réalisation de couches en matériaux semiconducteurs de types différents. L'invention concerne également l'application de ce procédé à la réalisation de dispositifs électroniques et optoélectroniques.

L'invention permet d'obtenir des couches minces monocristallines à faible densité de défauts, sur un substrat aussi monocristallin, en principe de nature distincte, et à partir de germes d'un troisième matériau.

A titre d'exemple, le procédé selon l'invention permet d'obtenir des couches minces d'InP de haute qualité cristalline sur substrat de silicium, à partir de germes de GaAs. De plus, le procédé selon l'invention permet d'obtenir des structures et des associations particulières de composants à base de matériau III-V (lasers, photodiodes, diodes gun, ... ) sur substrat de silicium.

L'hétéroépitaxie de couches minces de composés III-V de haute qualité cristallographique sur substrat de silicium, permet l'association de semiconducteurs à gaps directs et à forte mobilité avec un matériau technologiquement bien maîtrisé.

Il en résulte un champ d'applications extrêmement vaste, dans des domaines tels que l'optoélectronique intégrée (lasers et photodiodes à commande associée), les télécommunications optiques, les composants de puissance III-V, la connectique optique sur pastille de silicium ...

D'un point de vue technique, la croissance de composés III-V sur silicium s'effectue par MBE (Molecular Beam Epitaxy) ou MOVPE (OrganoMetallic Vapor Phase Epitaxy), ce qui conduit à des couches minces épitaxiées à densités de dislocations supérieures à 10⁶/cm² (voir le document J. Appl. Phys., 68, R31-190 de S. F. FANG et al), à partir desquelles il est impossible de fabriquer des composants optiques (lasers, photodiodes) présentant des durées de vie acceptables.

D'autre part, si l'épitaxie MBE et MOVPE de GaAs sur Si est relativement maîtrisée, celle d'InP est très délicate à mettre en oeuvre, la nucléation sur Si ne s'effectuant qu'à basse température.

De ce fait, il est difficile de décomposer la phosphine (PH₃) lorsque l'on travaille en "gaz source" MBE ou bien la phosphine et les organométalliques (Triméthyl ou Triéthylindium) lorsque l'on utilise la MOVPE ou la MOMBE (MetalOrganic Molecular Beam Epitaxy). Enfin l'utilisation de phosphore à basse température en MBE classique pose des problèmes de pompage. Dans tous les cas, les couches d'InP présentent des taux de dislocations supérieurs à 10⁶/cm² ainsi qu'indiqué ci-dessus.

Les Demandes de Brevets français n° 88 04437 et 88 04438 décrivent des procédés de croissance permettant d'améliorer de façon notable la qualité des couches hétéroépitaxiales de matériaux III-V sur substrat de silicium.

Des perfectionnements à ces procédés ont été décrits dans les Demandes de Brevets n° 90 12143 et 91 12352.

Dans les différents documents cités ci-dessus, l'hétéroépitaxie concernait un matériau B (par exemple GaAs) sur un substrat A (par exemple Si).

La présente invention concerne un procédé d'obtention d'un matériau C monocristallin et sans défauts (par exemple InP) à partir de germes d'un matériau B (par exemple GaAs) sur un substrat de matériau A (par exemple le silicium).

En prenant les exemples le matériaux indiqués ci-dessus, l'invention permet de réaliser une croissance "dirigée" d'InP de haute qualité cristallographique sur silicium, à partir de germes de GaAs de qualité très médiocre. On supprime de plus l'étape de croissance directe (MBE ou MOVPE) d'InP sur Si, forte délicate à mettre en oeuvre.

L'invention concerne donc un procédé de croissance de couches minces hétéroépitaxiales, caractérisé en ce qu'il comporte les étapes suivantes :
- croissance, sur une face d'un substrat monocristallin en un matériau de type (A), sur lequel il ne pourra y avoir ni nucléation, ni croissance lors de l'étape d'épitaxie qui va suivre, d'une couche d'un matériau monocristallin d'un premier type (B) ;
- dépôt d'une couche de confinement d'un matériau de type (D) sur lequel il ne pourra y avoir ni nucléation, ni croissance lors de l'étape d'épitaxie qui va suivre ;
- réalisation d'au moins une ouverture dans la couche de confinement ;
- attaque de la couche de matériau monocristallin, par l'ouverture de façon à ne laisser subsister qu'une partie (germe) de la couche de matériau monocristallin du premier type (B) et à obtenir une cavité communiquant avec le germe ;
- croissance, par épitaxie, d'un matériau d'un deuxième type (C) dans la cavité, à partir du germe de façon à obtenir dans la cavité un matériau monocristallin de deuxième type (C).

Les différents objets et caractéristiques de l'invention apparaîtront plus clairement dans la description qui va suivre et dans les figures annexées qui représentent :
- la figure 1, une vue générale du procédé de réalisation selon l'invention ;
- les figures 2a et 2b, des schémas explicatifs du procédé de l'invention ;
- les figures 3a à 3d, des étapes de réalisation du procédé selon l'invention ;
- les figures 4a à 4f, un exemple de réalisation détaillé du procédé selon l'invention ;
- la figure 5, une variante de réalisation selon l'invention ;
- les figures 6a à 6f, un autre exemple de réalisation détaillé du procédé de l'invention ;
- les figures 7a à 7d, une variante du procédé décrit en relation avec les figures 6a à 6f ;
- les figures 8a à 8c, un procédé de réalisation d'un dispositif optoélectronique ;
- la figure 9, une variante du procédé représenté par les figures 8a à 8b ;
- les figures 10 à 10c, un procédé de réalisation de plusieurs dispositifs associés.

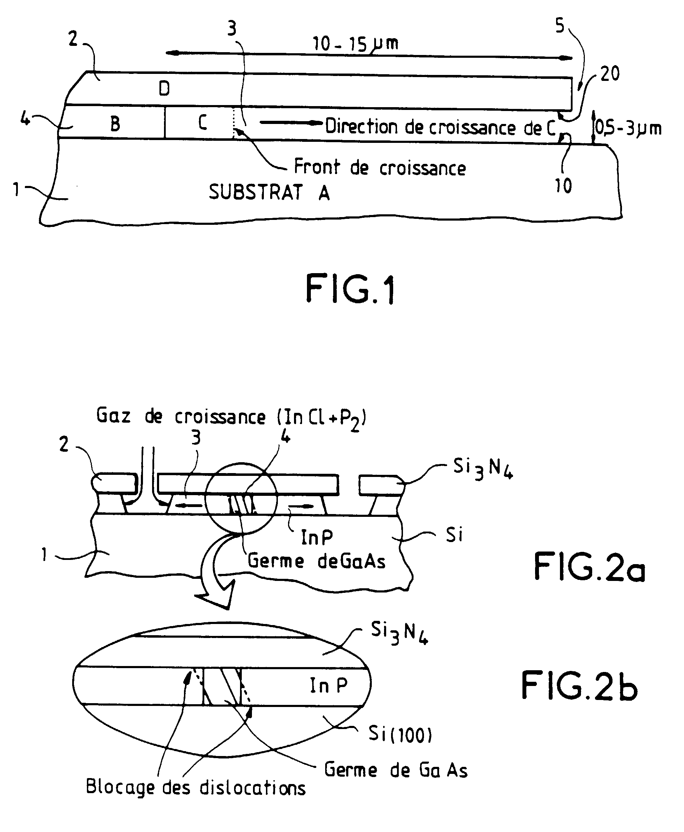

En se reportant à la figure 1, on va tout d'abord décrire de façon générale le procédé de l'invention.

Sur un substrat 1 en matériau A monocristallin, on réalise un germe 4 en matériau aussi monocristallin B enserré entre une face 10 du substrat 1 et une face 20 d'un élément (couche) de confinement 2 en matériau D.

Par une ouverture 5, on fait croître dans la cavité 3, à partir du germe 4, un matériau monocristallin C dont le front de croissance progresse comme indiqué par une flèche sur la figure 1. Comme on verra ci-après, une méthode de croissance préférée sera une épitaxie en phase vapeur (VPE) de chlorures ou d'hydrures.

Selon l'invention, le matériau C à faire croître est de type différent du matériau B du germe 4.

En ce qui concerne les matériaux A et D, ils peuvent être de nature chimiques différentes ou similaires, mais ils sont choisis de façon à ce que, lors de la croissance du matériau C, il ne puisse y avoir ni nucléation, ni croissance du matériau C sur les faces 10 et 20 dans les conditions de croissance choisies.

Selon les exemples de réalisation qui vont être décrits dans ce qui va suivre, les matériaux A et B sont différents. Cependant on peut également envisager qu'ils soient identiques.

A titre d'exemple, le matériau A du substrat 1 est du silicium, le matériau B du germe 4 est du GaAs et le matériau C à faire croître est de l'InP.

Le procédé de l'invention consiste à faire croître, par épitaxie dirigée sur silicium, le matériau tel que par exemple InP, à partir du germe en GaAs. Le blocage des dislocations d'adaptation générées à l'interface GaAs/InP lors de l'opération d'épitaxie s'effectue soit sur la surface 10 du silicium, soit sur la face 20 de l'élément 2 préalablement disposé au-dessus du germe de GaAs. Les figures 2a et 2b schématisent le principe de ce blocage des dislocations (les dislocations étant représentées sous forme de traits inclinés).

Afin d'éviter la nucléation parasite et d'obtenir aisément des conditions d'épitaxie sélective, l'élément 2 est constitué d'un matériau typiquement diélectrique, à haute barrière de nucléation. D'autre part, la nucléation sur la surface 10 du silicium est aussi évitée, à cause ici encore de la valeur intrinsèquement élevée de la barrière de nucléation d'InP sur Si mais aussi parce que cette surface 10 est partiellement passivée par de l'oxyde natif. On utilisera préférentiellement pour ce type de croissance une méthode qui permet de travailler au voisinage de l'équilibre thermodynamique pour la réaction globale de dépôt à savoir la VPE (Vapor Phase Epitaxy) aux chlorures ou bien la VPE aux hydrures (HVPE). Dans le premier cas, les précurseurs sont du trichlore de phosphore (PCl₃) et de l'indium, tandis que dans le deuxième cas, il s'agit de phosphine (PH₃) et d'indium.

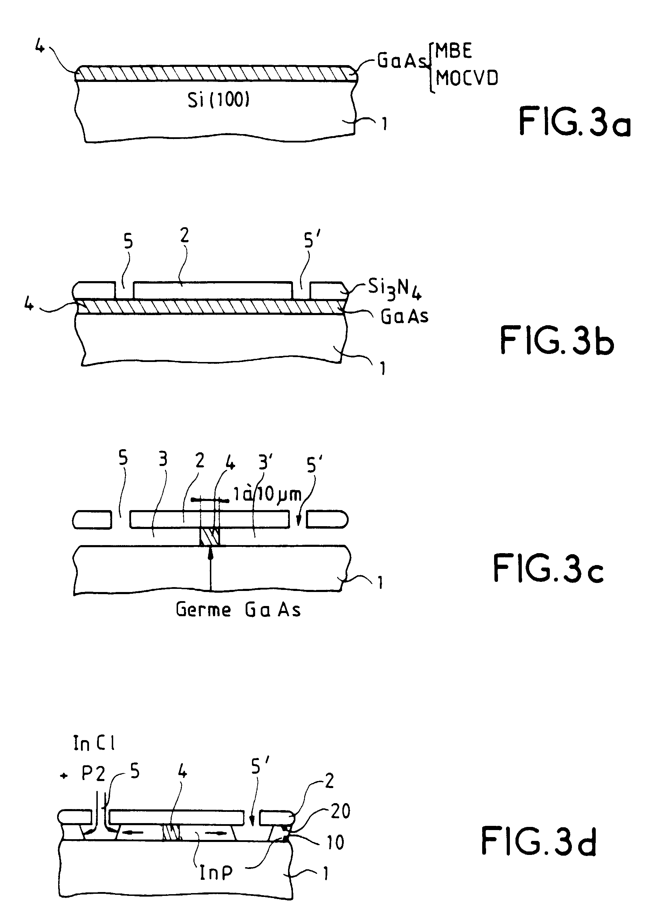

Les figures 3a à 3c décrivent succinctement une succession d'étapes technologiques de procédé selon l'invention permettant d'obtenir des couches minces d'InP sur Si à partir de germes de GaAs sur silicium.

On part d'une couche 4 de GaAs sur substrat 1 en silicium obtenue par MBE ou par MOCVD et présentant une densité de dislocations typiquement supérieure à 10⁶/cm² (figure 3a). On dépose sur l'ensemble une couche mince de Si₃N₄ ou de tout autre matériau adapté, dans laquelle on ouvre des ouvertures 5, 5' telles que des bandes parallèles de 1 à 20 µm de largeur, au pas de 10 à 200 µm (figure 3b). On élimine la majeur partie du GaAs de la couche 4 (soit chimiquement, soit en phase vapeur à 600-800°C, à l'aide de gaz chlorhydrique HCl) à travers les ouvertures 5, 5' précédemment gravées, de manière à ne conserver que des bandes 4 de, par exemple, 1 à 10 µm de largeur (figure 3c) qui serviront de germes. On épitaxie ensuite l'InP par les ouvertures 5, 5'. A partir des germes latéraux de GaAs tel que 4, la croissance s'effectue de façon confinée dans les cavités 3, 3' entre la surface inférieure 20 du chapeau 2 et la surface supérieure 10 de la plaquette de silicium (figure 3d). Du fait de ce confinement, les dislocations sont bloquées selon le mécanisme des figures 2a et 2b. On obtient ainsi de l'InP sans défauts sur silicium.

Bien que les dislocations soient bloquées, il peut se trouver que, dans le cas où le désaccord paramétrique de maille est trop important et/ou la différence des coefficients de dilatation thermique est trop importante, des fissures apparaissent dans le matériau obtenu par croissance dirigée (l'InP dans l'exemple ci-dessus) au-delà d'une certaine largeur de croissance.

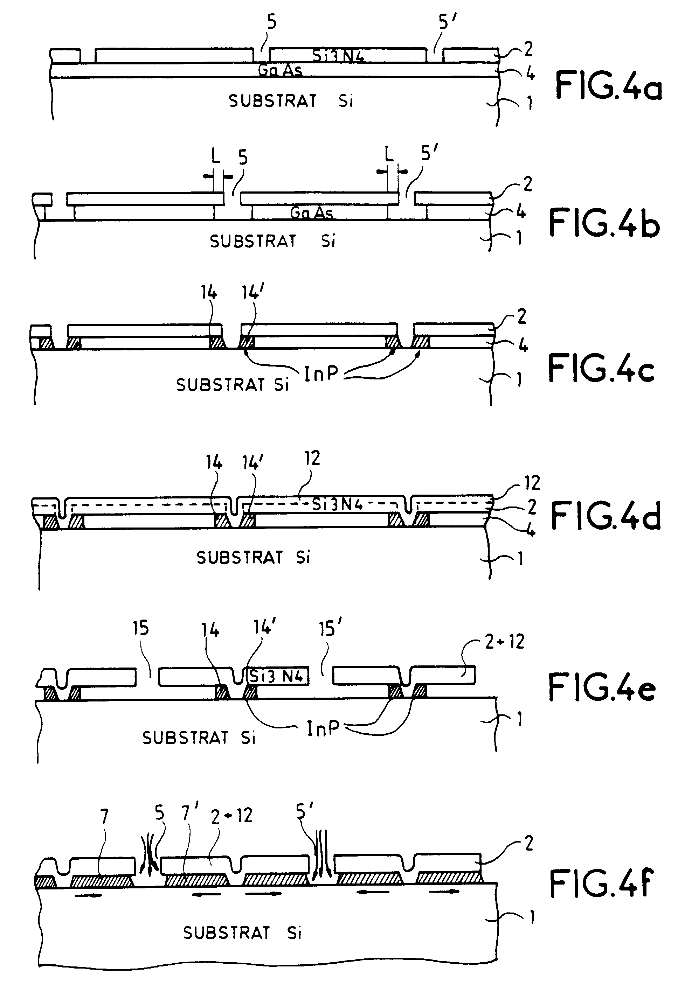

Afin de pallier cet inconvénient, l'invention prévoit de procéder en deux étapes pour la croissance dirigée, ainsi que schématisé sur les figures 4a à 4f.

De même que précédemment, on dépose une couche 2 de nitrure Si₃N₄, par exemple, sur une couche 4 de GaAs hétéroépitaxiée (par MBE ou MOCVD) sur un substrat 1 de silicium. On ouvre des ouvertures 5, 5' sous forme de bandes par exemples dans cette couche de nitrure (figure 4a). Pour les différentes caractéristiques géométriques, on se reportera aux commentaires de la figure 3b. A travers les ouvertures 5, 5' ainsi réalisées, on attaque très légèrement la couche 4 de GaAs, de façon à dégager, à partir des bords des bandes 5, 5', une largeur L inférieure à la largeur critique au-delà de laquelle les fissures sont susceptible d'apparaître lors de la réépitaxie du troisième matériau (l'InP dans l'exemple choisi). Typiquement, ce dégagement est de l'ordre de 0,5 à quelques micromètres (voir figure 4b). On effectue ensuite une première croissance (d'InP selon l'exemple choisi) à partir des flancs latéraux de GaAs laissés à nu après l'opération d'attaque. La largeur de cette croissance est maintenue en-deçà de la largeur critique correspondant à l'apparition des fissures (figure 4c). On obtient de nouveaux germes 14, 14', ... en InP.

On redépose sur l'ensemble une deuxième couche de Si₃N₄, de façon à obturer les ouvertures précédemment gravées (figure 4d).

En utilisant un deuxième masque (oui bien le même que celui ayant servir à pratiquer les premières ouvertures, mais translaté d'un demi pas) on ouvre une deuxième série de bandes 15, 15', dans les couches de nitrure (voir figure 4e) ; cette deuxième série de bandes sera préférentiellement disposée à mi-chemin entre les bandes précédentes 5, 5', ... A travers ces deuxièmes ouvertures on élimine la couche 4 de GaAs restant, par attaque chimique, de manière à ne conserver que les nouveaux germes 14, 14' d'InP (toujours selon l'exemple choisi). Pour cette attaque, on utilise de préférence un mélange chimique sélectif, de façon à ne pas avoir à contrôler l'attaque de l'InP. Cette dernière opération pourrait en effet s'avérer extrêmement délicate dans le cas où les bandes d'InP seraient de faible largeur. La structure ainsi obtenue est représentée à la figure 4e. On utilise enfin les germes 14, .14',... d'InP pour refaire croître en épitaxie dirigée des couches 7, 7', ... d'InP sans défauts sur substrat silicium (voir figure 4f).

Pour différentes raisons, et selon la nature des composants que l'on veut fabriquer dans les couches de matériaux III-V sur silicium, on peut vouloir isoler la couche mince du substrat.

L'invention prévoit dans ce cas une oxydation chimique de la surface du substrat 1 en silicium, après attaque de la couche 4 de matériau B (GaAs en l'occurence) et avant croissance par épitaxie dirigée du matériau C (InP). Pour fabriquer cet oxyde chimique sur la surface 10 du substrat silicium on pourra utiliser une solution de H₂O₂/H₂SO₄, ou bien encore une solution de HNO₃. Selon le temps d'exposition et la concentration des solutions en question, on obtiendra des épaisseurs de couche 8 de SiO₂ "chimique" de quelques dizaines à quelques centaines d'angstroëms.

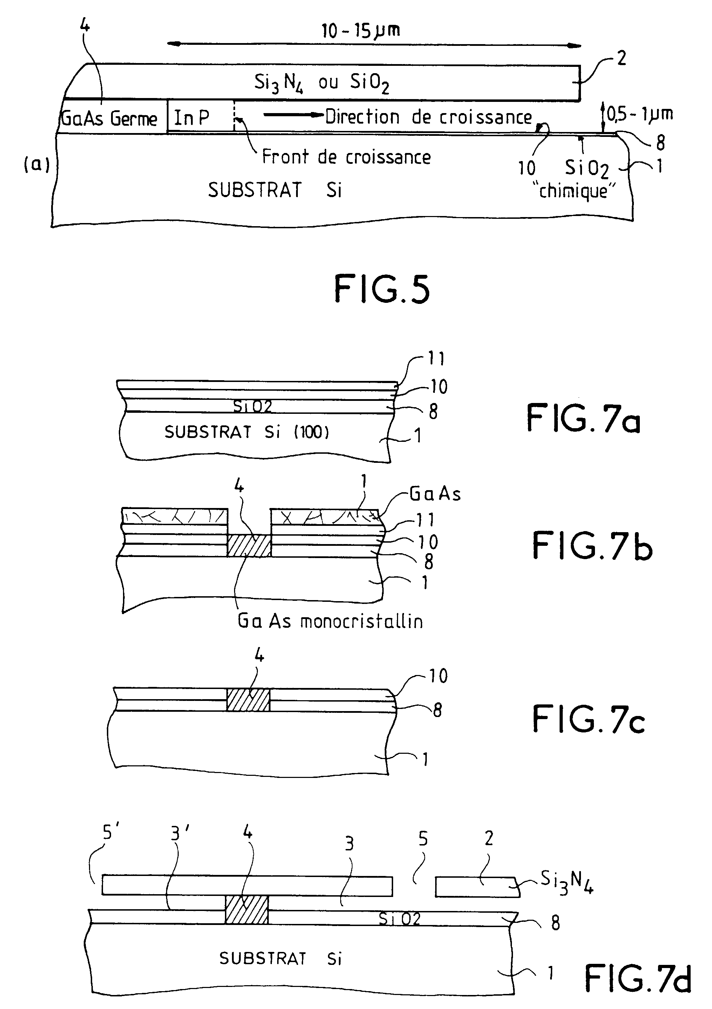

La figure 5 représente un tel procédé de croissance après l'oxydation chimique de la face 10 du substrat 1.

Si l'on veut obtenir une couche 8 d'oxyde de meilleure qualité à la surface du substrat de silicium, voire un oxyde thermique, on utilisera comme substrat de départ une plaquette de silicium de type SOI (Silicon On Insulator). Différentes techniques sont couramment utilisées pour réaliser les plaquettes SOI, et on pourra consulter par exemple le document IEEE CIRCUITS AND DEVICES MAGAZINE, Vol 3, Nos 4 et 6 de Juillet et Novembre 1987 pour obtenir de nombreux détails sur ces techniques.

Dans l'exemple qui suit, on utilise une plaquette SOI de type SIMOX (Separation by IMplantation of OXygen) mais on pourrait tout aussi bien utiliser des plaquettes SOI de type SDB (Silicon Direct Bonding) ou ZMR (Zone Melting Recrystallization) etc...

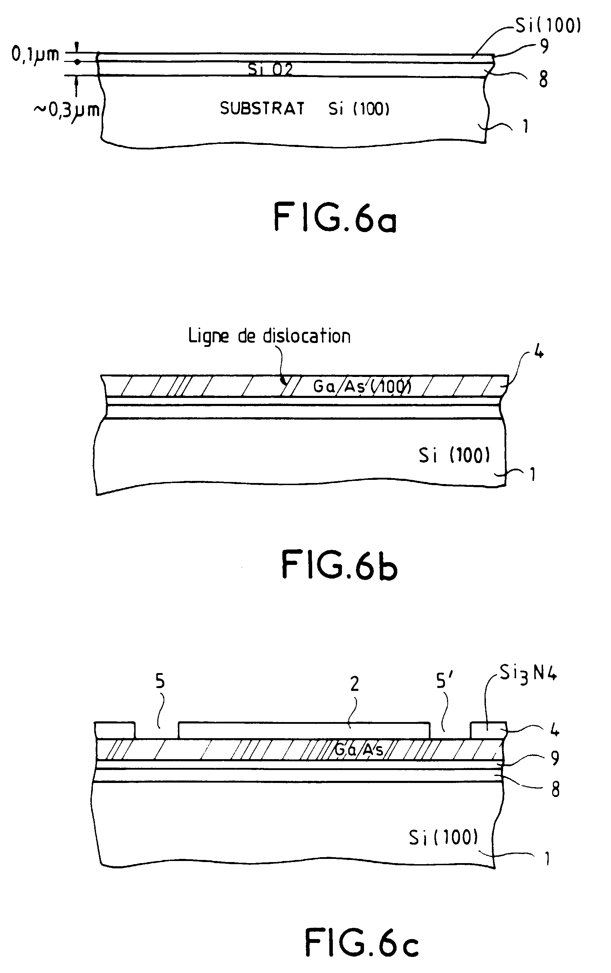

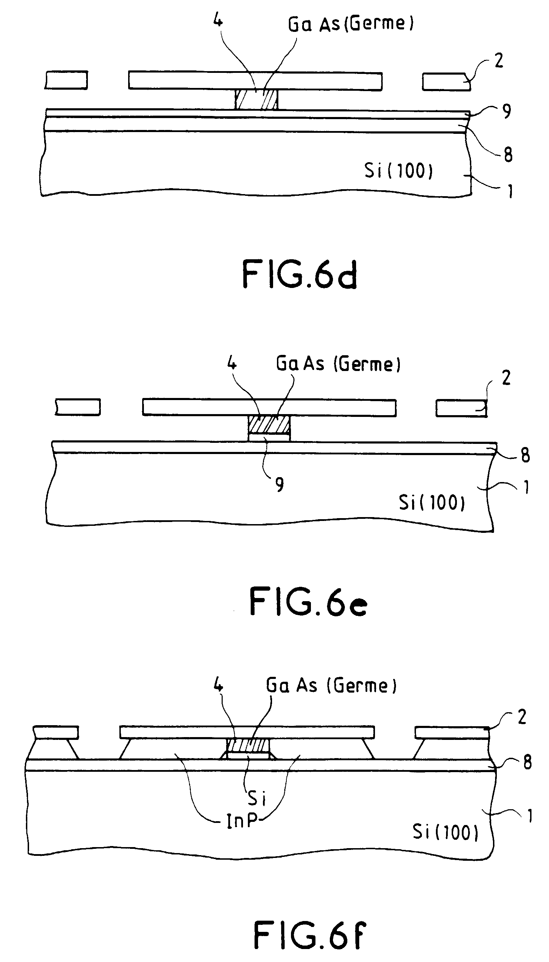

Les figures 6a à 6f décrivent une succession d'étapes technologiques permettant d'obtenir des couches minces isolées du substrat par un oxyde de qualité.

On part donc d'une plaquette de type SIMOX comprenant une couche 8 de SiO₂ et une couche 9 de Si (100) (figure 6a) sur laquelle on épitaxie par MBE ou MOVPE une couche mince 4 de GaAs (figure 6b) qui présentera donc plus de 10⁶ dislocations/cm². On dépose une couche 2 de Si₃N₄ dans laquelle, de même que précédemment, on pratique une série d'ouvertures 5, 5', sous forme de bandes parallèles par exemple (figure 6c). On attaque successivement la couche 4 de GaAs pour former des germes 4 (voir figure 6d) puis la couche 9 de silicium (voir figure 6e). Ensuite on effectue la croissance dirigée de l'InP par les ouvertures 5, 5' à partir des germes 5 de GaAs. De même que dans le cas de la figure 1, il n'y a pas de nucléation de l'InP sur les flancs du Si (couche 9) sous-jacent en germe de GaAs si la croissance dirigée de l'InP est effectuée en VPE par exemple.

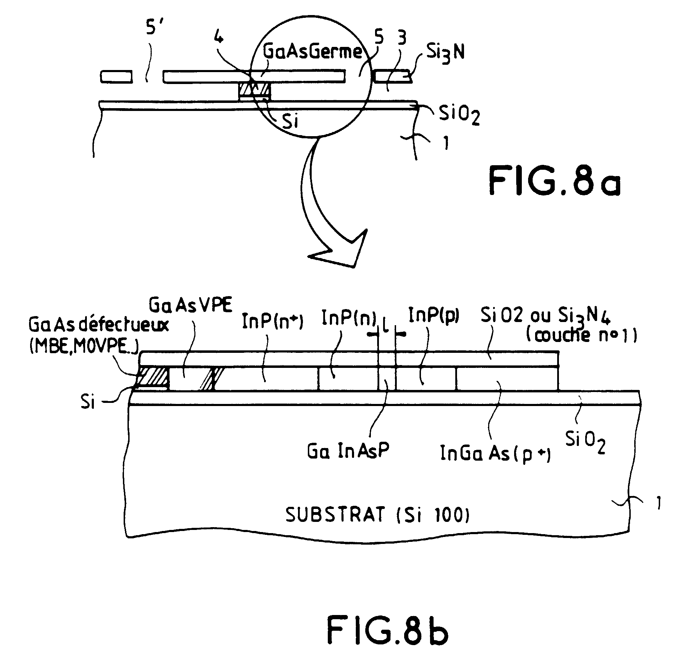

Les figures 7a à 7d représentent une variante de réalisation pour faire un germe en matériau B à une extrémité d'une cavité 3 entourée de matériau isolant dont un oxyde thermique.

Selon la figure 7a on réalise sur un substrat 1 en silicium par exemple, une couche 8 d'oxyde thermique (SiO₂ thermique) puis une couche 10 de semiconducteur amorphe (Si amorphe) et enfin une couche 11 d'un matériau différent des deux précédents (8 et 10), par exemple d'un métal tel que de l'aluminium.

On grave, dans l'ensemble le ces couches, les ouvertures ; on réalise une épitaxie d'un matériau (GaAs) en vue de la réalisation des germes 4. Le matériau GaAs déposé dans les ouvertures sur le substrat Si est monocristallin 4 et il est polycristallin sur la couche 11 d'aluminium.

L'épitaxie est telle que l'épaisseur des germes 4 permet d'atteindre la face supérieure de la couche 10 (figure 7b).

Ensuite on attaque la couche 11 d'aluminium de manière à réaliser le "lift off" (le retrait) de la couche 13 de GaAs polycristallin (figure 7c ).

On recouvre l'ensemble par une couche 2 d'isolant (Si₃N₄) et on pratique des ouvertures 5, 5' dans la couche 2. Par les ouvertures 5, 5' on attaque le silicium amorphe 10 et on obtient des cavités 3, 3' (figure 7d).

On peut maintenant réaliser une épitaxie dirigée d'InP par les ouvertures 5, 5' à partir des germes tels que 4 et on obtient alors une couche d'InP sur silice thermique 8.

Les différentes méthodes d'isolation décrites ci-dessus sont nécessaires lorsque des composants sont réalisés par épitaxie dirigée sur silicium. Ainsi, les figures 8a à 8c décrivent à titre d'exemple la réalisation d'un laser InP/GaInAsP/InP obtenu par épitaxie dirigée, mais en modulant le dopage et la composition des matériaux épitaxiés dans la cavité 3 de la figure 8a.

On part, par exemple, d'une structure du type de celle représentée sur la figure 6e et reportée sur la figure 8a. On peut commencer par faire croître par VPE une couche de GaAs, à partir du germe 4, de façon à améliorer la qualité cristalline du germe ; dans la majorité des cas, ceci n'est pas nécessaire. Les bandes 5 et 5' dans le nitrure 2 auront de préférence été préalablement orientées selon une direction [110] du plan du substrat (d'orientation (100). Les bandes de germe 4 conservent cette orientation [110]. Ceci permet d'obtenir lors de la croissance dirigée une facette latérale unique. On réalise ainsi une incorporation homogène des dopants, lors de la croissance dirigée. Sur la figure 8b, on a représenté le cas où l'on obtient une facette de croissance latérale de type (110). Après la croissance de GaAs, on effectue une croissance d'InP dopé n⁺, puis d'InP dopé n. On épitaxie ensuite le matériau quaternaire GaₓIn₁₋ₓAs_{y}P_{1-y} dont le paramètre de maille est adapté à l'InP. Selon la longueur d'onde laser que l'on désire obtenir, on choisira par exemple x = 0,27 et y = 0,60. ou bien x = 0,40 et y = 0,85, ou bien encore x = 0,47 et y = 1.

La largeur l du quaternaire sera typiquement de l'ordre de 0,1 à 0,8 µm.

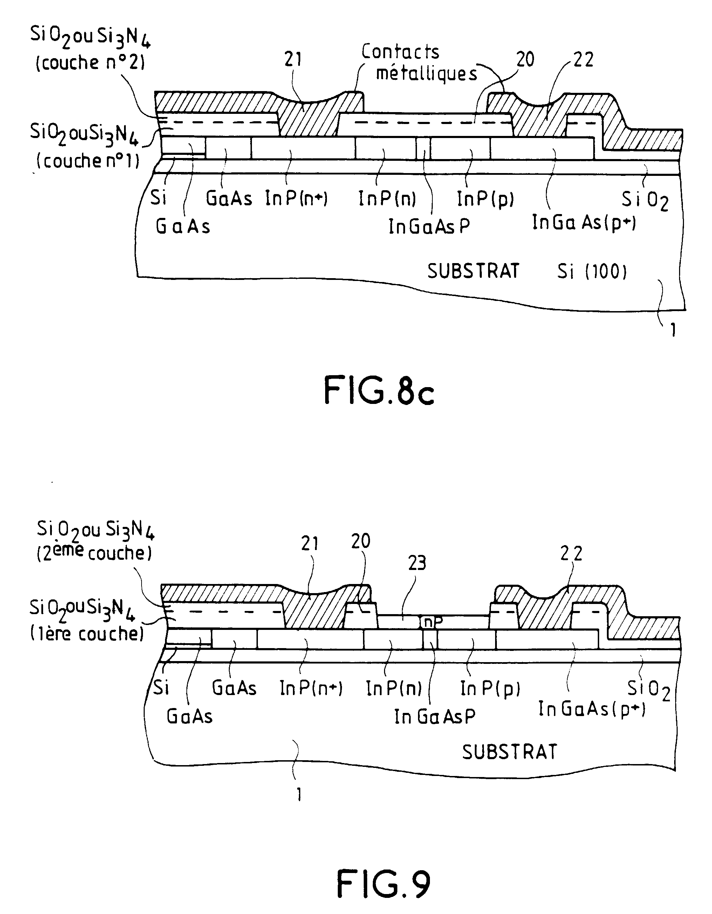

On effectue enfin une croissance d'InP (p) suivie d'une croissance de InGaAs (p⁺) sur laquelle il sera aisé de prendre un contact ohmique. La succession des couches ainsi réalisées est représentée sur la figure 8b. Enfin, on redépose sur l'ensemble une couche 20 de Si₃N₄ ou de SiO₂ pour passiver. On ouvre des fenêtres pour les prises de contacts 21, 22. On dépose les contacts 21, 22 et on les grave. La figure 8c représente la structure de laser à électrodes coplanaires ainsi obtenue.

Afin d'améliorer l'interface supérieure de la couche active de GaInAsP, on peut comme représenté en figure 9, graver la couche 20 de Si₃N₄ localement et effectuer par reprise d'épitaxie sélective une croissance d'une couche 23 d'InP soit semi-isolant soit dopé. On évite ainsi une recombinaison excessive à l'interface supérieure de GaInAsP, ce qui aurait pour effet de diminuer la durée de vie du laser.

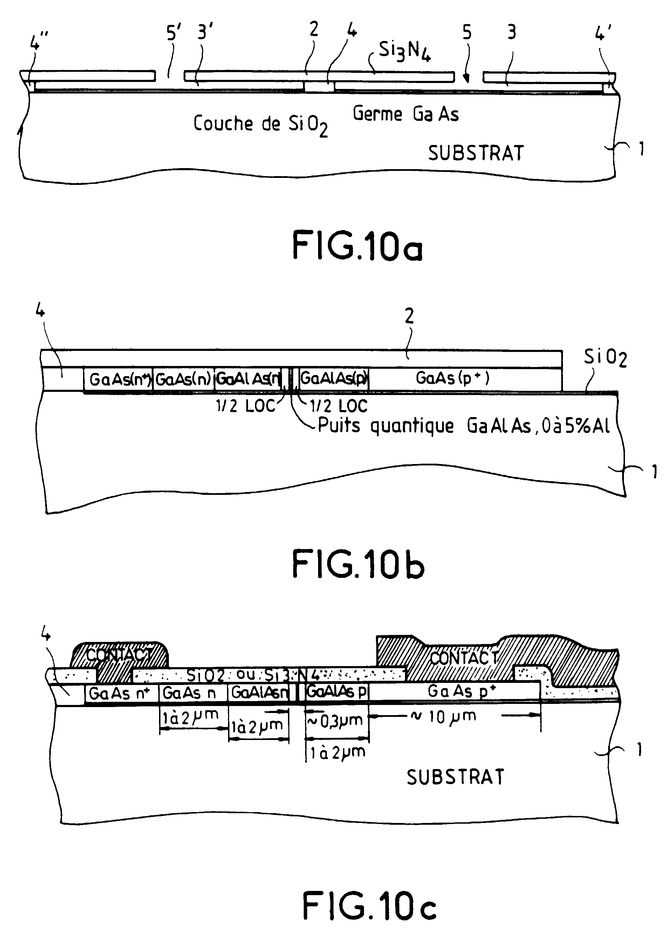

Sur un même substrat, il est possible de fabriquer des composants de types différents. En effet sur le substrat 1 de la figure 10a, on a représenté, par exemple, deux cavités 3 et 3' avec des germes 4, 4', 4''. La cavité 3 peut servir à réaliser un ou deux composants d'un premier type en effectuant une croissance épitaxiale à partir des germes 4, 4'. La cavité 3' peut servir à réaliser un ou deux composants d'un deuxième type. Pour cela, il suffit de faire croître des matériaux de compositions et/ou de dopage différents dans les deux cavités.

Par exemple, si dans la cavité 3 on a fait croître une structure telle que celle décrite précédemment en relation avec les figures 8a à 8c, il est clair que sur le même substrat de silicium, dans la cavité 3', on peut fabriquer aussi par un procédé identique des lasers de type GaAs/GaAlAs. Les figures 10b et et 10c décrivent une telle structure à puits quantique,

Comme représenté sur la figure 10b, on fait croître à partir d'un germe de GaAs, successivement les matériaux suivants :
GaAs (n⁺)
GaAs (n)
GaAlAs (n)
1/2 cavité optique GaAlAs avec Al varient continûment de 20 à 40 %
1 puits quantique GaAlAs avec Al choisi entre 0 et 5 %
1/2 cavité optique GaAlAs avec Al variant continûment de 20 à 40 %
GaAlAs (p)
GaAs (p⁺)

Après réalisation d'une couche d'isolant sur la structure et réalisation de contacts, on obtient la structure représentée en figure 10c sur laquelle on a indiqué à titre d'exemple des dimensions des différentes zones de matériaux précédents.

Si un laser GaAs/GaAlAs tel que représenté en figure 10c et un laser InP/GaInAsP/InP tel que celui de la figure 8c doivent être réalisés sur le même substrat, on commencera par réaliser la structure GaAs/GaAlAs de la figure 10b, celle-ci s'effectuant à plus haute température. On réalisera ensuite la structure de la figure 8b, correspondant au deuxième type de laser. Enfin les métallisations et les gravures correspondant aux figures 8c et 10c seront effectuées en dernier lieu.

Il est clair que les structures et dispositifs ci-dessus ne représentent que des exemples particuliers. On peut aussi réaliser selon la technique des transistors, diodes gun InP, des photodiodes de type GaInAs ou de tout autre type.

## Revendications

1. Procédé de croissance de couches minces hétéroépitaxiales, caractérisé en ce qu'il comporte les étapes suivantes :
- croissance, sur une face (10) d'un substrat monocristallin en un matériau de type (A) sur lequel il ne pourra y avoir ni nucléation, ni croissance lors de l'étape d'épitaxie qui va suivre, d'une couche (4) d'un matériau monocristallin d'un premier type (B) ;
- dépôt d'une couche de confinement (2) d'un matériau de type (D) sur lequel il ne pourra y avoir ni nucléation, ni croissance lors de l'étape d'épitaxie qui va suivre ;
- réalisation d'au moins une ouverture (5, 5') dans la couche de confinement (2) ;
- attaque de la couche de matériau monocristallin (4), par l'ouverture (5, 5') de façon à ne laisser subsister qu'une partie (germe) de la couche de matériau monocristallin (4) du premier type (B) et à obtenir une cavité (3) communiquant avec le germe ;
- croissance, par épitaxie, d'un matériau d'un deuxième type (C) dans la cavité (3), à partir du germe (4) de façon à obtenir dans la cavité (3) un matériau monocristallin de deuxième type (C).

2. Procédé selon la revendication 1, caractérisé en ce que le matériau de la couche de confinement (2) est un matériau isolant.

3. Procédé selon la revendication 1, caractérisé en ce que le substrat (1) est du silicium, le matériau de la couche de confinement est un isolant tel qu'un nitrure de silicium ou de la silice, le matériau du premier type (B) du germe (4) est du GaAs, le matériau du deuxième type (C) à faire croître est de l'InP.

4. procédé selon la revendication 1, caractérisé en ce que la croissance du matériau du deuxième type (C) se fait par épitaxie en phase vapeur à partir du germe (4).

5. Procédé selon la revendication 4, caractérisé en ce que la croissance se fait par épitaxie en phase vapeur de chlorures ou d'hydrures.

6. Procédé de croissance de couches minces hétéroépitaxiales selon la revendication 1, caractérisé en ce que le matériau du deuxième type (C) est utilisé comme deuxième germe (14, 14') et en ce qu'il comporte les étapes supplémentaires suivantes :
- réalisation d'au moins une deuxième ouverture (15, 15') dans la couche de confinement, au-dessus du matériau du premier type (B) ;
- attaque par la deuxième ouverture (15, 15'), du matériau du premier type (B) ;
- croissance, par épitaxie, d'un matériau du deuxième type (C) par la deuxième ouverture (15, 15'), à partir du deuxième germe (14, 14') en matériau du deuxième type (C).

7. Procédé selon la revendication 6, caractérisé en ce qu'il comporte avant la réalisation de la deuxième ouverture (15, 15') une étape de dépôt d'une autre couche d'isolant (12).

8. Procédé selon l'une des revendications 1 ou 6, caractérisé en ce qu'il comporte avant la croissance par épitaxie du matériau du deuxième type (C), une étape d'oxydation de la face (10) du substrat (1).

9. Procédé selon la revendication 1, caractérisé en ce que le substrat est en matériau isolant.

10. Procédé selon l'une des revendications 1 ou 6, caractérisé en ce que le substrat (1) est en silicium monocristallin et comporte une couche d'oxyde (8) et une couche (9) de silicium monocristallin empilées, et que l'attaque de la couche de matériau monocristallin (4) est suivie d'une attaque de la couche (9) de silicium monocristallin.

11. Procédé selon l'une des revendications 1 ou 6, caractérisé en ce que la croissance par épitaxie se fait successivement avec des matériaux de compositions et/ou de dopages différents.

12. Procédé selon la revendication Il appliqué à la réalisation d'un laser, caractérisé en ce que le germe (4, 14) étant en GaAs, les matériaux épitaxiés dans la cavité (3) sont successivement les suivants :
GaAs servant de germe intermédiaire
InP (n⁺)
InP (n)
InGaAsP
InP (p)
InGaAs (p⁺)
et que l'ensemble est recouvert d'isolant, des contacts ohmiques (20, 21) traversant cet isolant étant réalisés pour être connectés à l'InP (n⁺) d'une part et l'InGaAs (p⁺) d'autre part.

13. Procédé selon la revendication 12, caractérisé en ce qu'au dessus du matériau InGaAsP, l'isolant est enlevé et une couche d'InP est déposée à sa place.

14. Procédé selon la revendication 11, caractérisé en ce que plusieurs cavités sont réalisées et que des épitaxies avec des matériaux de compositions et/ou de dopages différents sont réalisées dans les différentes cavités.

15. Procédé selon la revendication Il appliqué à la réalisation d'un laser, caractérisé en ce que le germe étant en GaAs, les matériaux épitaxiés dans la cavité (3') sont successivement
GaAs (n⁺)
GaAs (n)
GaAlAs (n)
1/2 cavité optique GaAlAs avec AI varient continûment de 20 à 40 %
1 puits quantique GaAlAs avec AI choisi entre 0 et 5 %
1/2 cavité optique GaAlAs avec AI variant continûment de 20 à 40 %
GaAlAs (p)
GaAs (p⁺)

16. Procédé selon l'une des revendications 12 ou 15, caractérisé en ce que le substrat est en silicium monocristallin.

17. Procédé selon l'une des revendications 12 ou 15, caractérisé en ce qu'un laser en GaAs et un laser en InP sont réalisés sur un même substrat, le laser en GaAs étant réalisé avant le laser InP.

## Patentansprüche

1. Verfahren zum Aufwachsen von heteroepitaktischen Dünnschichten, dadurch gekennzeichnet, daß es die folgenden Schritte umfaßt:
- Aufwachsen einer Schicht (4) aus einem monokristallinen Material eines ersten Typs (B) auf einer Seite (10) eines monokristallinen Substrats aus einem Material des Typs (A), auf dem beim folgenden Epitaxieschritt weder eine Nukleation noch ein Aufwachsen stattfinden kann;
- Aufbringen einer Einschlußschicht (2) aus einem Material des Typs (D), auf dem beim folgenden Epitaxieschritt weder eine Nukleation noch ein Aufwachsen stattfinden kann;
- Herstellung wenigstens einer Öffnung (5, 5') in der Einschlußschicht (2);
- Angriff auf die Schicht (4) aus monokristallinem Material durch die Öffnung (5, 5'), so daß nur ein Teil (Keim) der Schicht aus monokristallinem Material (4) des ersten Typs (B) bleibt und ein Hohlraum (3) erhalten wird, der mit dem Keim in Verbindung steht;
- epitaktisches Aufwachsen eines Materials eines zweiten Typs (C) in dem Hohlraum (3) ausgehend von dem Keim (4), so daß in dem Hohlraum (3) ein monokristallines Material des zweiten Typs (C) erhalten wird.

2. Verfahren nach Anspruch 1, dadurch gekennzeichnet, daß das Material der Einschlußschicht (2) ein Isoliermaterial ist.

3. Verfahren nach Anspruch 1, dadurch gekennzeichnet, daß das Substrat (1) Silicium ist, das Material der Einschlußschicht ein Isolierstoff wie Siliciumnitrid oder Siliciumdioxid ist, das Material des ersten Typs (B) des Keims (4) GaAs ist und das aufzuwachsende Material des zweiten Typs (C) InP ist.

4. Verfahren nach Anspruch 1, dadurch gekennzeichnet, daß das Aufwachsen des Materials des zweiten Typs (C) durch Gasphasenepitaxie ausgehend von dem Keim (4) stattfindet.

5. Verfahren nach Anspruch 4, dadurch gekennzeichnet, daß das Aufwachsen durch Gasphasenepitaxie von Chloriden oder Hydriden stattfindet.

6. Verfahren zum Aufwachsen von heteroepitaktischen Dünnschichten nach Anspruch 1, dadurch gekennzeichnet, daß das Material des zweiten Typs (C) als zweiter Keim (14, 14') verwendet wird, und daß es die folgenden zusätzlichen Schritte umfaßt:
- Herstellung wenigstens einer zweiten Öffnung (15, 15') in der Einschlußschicht über dem Material des ersten Typs (B);
- Angriff auf das Material des ersten Typs (B) durch die Öffnung (15, 15');
- epitaktisches Aufwachsen eines Materials eines zweiten Typs (C) durch die zweite Öffnung (15, 15') ausgehend von dem zweiten Keim (14, 14') aus einem Material des zweiten Typs.

7. Verfahren nach Anspruch 6, dadurch gekennzeichnet, daß es vor der Herstellung der zweiten Öffnung (15, 15') einen Schritt des Aufbringens einer weiteren Isolierschicht (12) umfaßt.

8. Verfahren nach einem der Ansprüche 1 oder 6, dadurch gekennzeichnet, daß es vor dem epitaktischen Aufwachsen des Materials des zweiten Typs (C) einen Schritt der Oxidation der Seite (10) des Substrats (1) umfaßt.

9. Verfahren nach Anspruch 1, dadurch gekennzeichnet, daß das Substrat aus Isoliermaterial besteht.

10. Verfahren nach einem der Ansprüche 1 oder 6, dadurch gekennzeichnet, daß das Substrat (1) aus monokristallinem Silicium besteht und aufeinandergestapelt eine Oxidschicht (8) und eine Schicht (9) aus monokristallinem Silicium aufweist, und daß auf den Angriff auf die Schicht (4) aus monokristallinem Material ein Angriff auf die Schicht (9) aus monokristallinem Silicium folgt.

11. Verfahren nach einem der Ansprüche 1 oder 6, dadurch gekennzeichnet, daß das epitaktische Aufwachsen nacheinander mit Materialien mit unterschiedlichen Zusammensetzungen und/oder Dotierungen stattfindet.

12. Verfahren nach Anspruch 11, das auf die Herstellung eines Lasers angewendet wird, dadurch gekennzeichnet, daß bei einem Keim (4, 14) aus GaAs die in dem Hohlraum (3) epitaktisch aufgebrachten Materialien nacheinander folgende sind:
GaAs, das als Zwischenkeim dient,
InP (n⁺)
InP (n)
InGaAsP
InP (p)
InGaAs (p⁺),
und daß die Einheit mit einem Isolierstoff überdeckt wird, wobei ohmsche Kontakte (20, 21) diesen Isolierstoff durchsetzen, die zum Anschluß an das InP (n⁺) einerseits und das InGaAs (p⁺) andererseits hergestellt sind.

13. Verfahren nach Anspruch 12, dadurch gekennzeichnet, daß der Isolierstoff über dem InGaAsP-Material entfernt und an seiner Stelle eine InP-Schicht aufgebracht wird.

14. Verfahren nach Anspruch 11, dadurch gekennzeichnet, daß mehrere Hohlräume hergestellt werden, und in den verschiedenen Hohlräumen Epitaxien mit Materialien mit unterschiedlichen Zusammensetzungen und/oder Dotierungen durchgeführt werden.

15. Verfahren nach Anspruch 11, das auf die Herstellung eines Lasers angewendet wird, dadurch gekennzeichnet, daß bei einem Keim aus GaAs die in dem Hohlraum (3') epitaktisch aufgebrachten Materialien nacheinander folgende sind:
GaAs (n⁺)
GaAs (n)
GaAlAs (n)
1/2 optischer Hohlraum GaAlAs, wobei Al kontinuierlich von 20 bis 40 % variiert
1 Quantentopf GaAlAs, wobei Al zwischen 0 und 5 % gewählt ist
1/2 optischer Hohlraum GaAlAs, wobei Al kontinuierlich von 20 bis 40 % variiert
GaAlAs (p)
GaAs (p⁺).

16. Verfahren nach einem der Ansprüche 12 oder 15, dadurch gekennzeichnet, daß das Substrat aus monokristallinem Silicium besteht.

17. Verfahren nach einem der Ansprüche 12 oder 15, dadurch gekennzeichnet, daß ein Laser aus GaAs und ein Laser aus InP auf ein und demselben Substrat hergestellt werden, wobei der Laser aus GaAs vor dem InP-Laser hergestellt wird.

## Claims

1. Process for growing heteroepitaxial thin films, characterized in that it includes the following steps:
- growth, on one face (10) of a monocrystalline substrate made of a type (A) material on which neither nucleation nor growth can take place during the epitaxy step which will follow, of a layer (4) of a monocrystalline material of a first type (B);
- deposition of a confinement layer (2) of a type (D) material on which neither nucleation nor growth can take place during the epitaxy step which will follow;
- production of at least one opening (5, 5') in the confinement layer (2);
- etching of the layer of monocrystalline material (4) through the opening (5, 5') so as to leave remaining only a part (seed) of the layer of monocrystalline material (4) of the first type (B) and to obtain a cavity (3) communicating with the seed;
- growth, by epitaxy, of a material of a second type (C) in the cavity (3), starting from the seed (4), so as to obtain a monocrystalline material of second type (C) in the cavity (3).

2. Process according to Claim 1, characterized in that the material of the confinement layer (2) is an insulating material.

3. Process according to Claim 1, characterized in that the substrate (1) is silicon, the material of the confinement layer is an insulant such as silicon nitride or silica, the material of the first type (B) of the seed (4) is GaAs, the material of the second type (C) to be grown is InP.

4. Process according to Claim 1, characterized in that the material of the second type (C) is grown by vapour phase epitaxy starting from the seed (4).

5. Process according to Claim 4, characterized in that the growth is carried out by chloride or hydride vapour phase epitaxy.

6. Process for growing heteroepitaxial thin films according to Claim 1, characterized in that the material of the second type (C) is used as second seed (14, 14'), and in that it includes the following additional steps:
- production of at least a second opening (15, 15') in the confinement layer, above the material of the first type (B);
- etching of the material of the first type (B) through the second opening (15, 15');
- growth, by epitaxy, of a material of the second type (C) through the second opening (15, 15'), starting from the second seed (14, 14') made of material of the second type (C).

7. Process according to Claim 6, characterized in that, before the production of the second opening (15, 15'), it includes a step of depositing another layer of insulant (12).

8. Process according to one of Claims 1 or 6, characterized in that, before the growth of the material of the second type (C) by epitaxy, it includes a step of oxidizing the face (10) of the substrate (1).

9. Process according to Claim 1, characterized in that the substrate is made of insulating material.

10. Process according to one of Claims 1 or 6, characterized in that the substrate (1) is made of monocrystalline silicon and includes an oxide layer (8) and a monocrystalline silicon layer (9) which are stacked, and in that the etching of the layer of monocrystalline material (4) is followed by etching of the monocrystalline silicon layer (9).

11. Process according to one of Claims 1 or 6, characterized in that the growth by epitaxy takes place successively with materials of different compositions and/or doping.

12. Process according to Claim 11, applied to the production of a laser, characterized in that, the seed (4, 14) being made of GaAs, the materials growing epitaxially in the cavity (3) are, in order, as follows:
GaAs used as intermediate seed
InP (n⁺)
InP (n)
InGaAsP
InP (p)
InGaAs (p⁺)
and in that the assembly is covered with insulant, ohmic contacts (20, 21) passing through this insulant being produced in order to be connected to the InP (n⁺), on the one hand, and the InGaAs (p⁺) on the other hand.

13. Process according to Claim 12, characterized in that, above the InGaAsP material, the insulant is removed and an InP layer is deposited in its place.

14. Process according to Claim 11, characterized in that a plurality of cavities are produced, and in that epitaxial growth with materials of different compositions and/or doping is carried out in the various cavities.

15. Process according to Claim 11, applied to the production of a laser, characterized in that, the seed being made of GaAs, the materials epitaxially grown in the cavity (3') are, in order
GaAs (n⁺)
GaAs (n)
GaAlAs (n)
1/2 optical cavity, GaAlAs with Al varying continuously from 20 to 40%
1 quantum well, GaAlAs with Al selected between 0 and 5%
1/2 optical cavity, GaAlAs with Al varying continuously from 20 to 40%
GaAlAs (p)
GaAs (p⁺)

16. Process according to one of Claims 12 or 15, characterized in that the substrate is made of monocrystalline silicon.

17. Process according to one of Claims 12 or 15, characterized in that a GaAs laser and an InP laser are produced on the same substrate, the GaAs laser being produced before the InP laser.
